# EUROPEAN PATENT APPLICATION

(11) **EP 1 408 135 A1**
(43) Date of publication of application: **14.04.2004**
(21) Application number: 02425603.4
(22) Date of filing: 08.10.2002
(51) Int. Cl.: C23C 14/24, C23C 14/26, C23C 14/56

(54) **Apparatus for physical vapour deposition**

(71) Applicant: Galileo Vacuum Systems S.R.L., 59100 Prato (IT)
(72) Inventor: Rimediotti, Fabriano, 59100 Prato (IT); Ceni, Mario, 50018 Scandicci, Firenze (IT)
(74) Representative: Mannucci, Michele

(57) **Abstract**

The plant comprises: A plurality of vaporization sources (33) supplied with a metal which is liquefied and vaporized by said sources; means for feeding the substrate above said sources, in a feeding direction (FN), said sources being arranged alongside each other in an alignment substantially perpendicular to the feeding direction; means (51) for supplying metal wire (F) to said sources; means for supporting and heating said sources. Each of said sources is suitable for forming thereon at least two pools of molten metal, with two or more cavities (41A, 41B) or equivalent means, preferably aligned in the main direction (DL) of the source itself.

## Description

### Technical field

The present invention relates to a plant for the metallization, by means of vacuum vaporization, of a web-like substrate, for example a film of plastic material, on which a coating of metal or the like must be formed.

More particularly, the invention relates to a vacuum vaporization plant for the metallization of a web-like substrate, of the type comprising:
- a plurality of vaporization sources supplied with a metal which is liquefied and vaporized by said sources, each source having a body elongated in a respective main longitudinal direction;
- means for feeding the substrate above the sources, in a feeding direction, said sources being arranged alongside each other in an alignment substantially perpendicular to the direction of feeding of the substrate to be metallized;
- means for supplying metal wire to the sources;
- means for supporting and heating the sources.

Another aspect of the present invention relates to a new type of vacuum vaporization source.

### State of the art

For the vacuum metallization of plastic films or other continuous web-like substrates, vacuum-vaporization metallization plants, in which a substrate in the form of a film or the like is unwound from a storage reel, driven around a processing roller and rewound onto a reel of processed material, are known. In the zone where driving around the processing roller occurs the substrate passes in front of a series of vaporization sources which are located - as is at least a part of the processing roller - inside a vacuum chamber inside which a cloud of metallic material vaporized by the source is formed. This metallic material is deposited by means of condensation onto the substrate which is then rewound onto the reel of processed material.

The process is a process of the discontinuous type, since individual reels of substrate to be processed are introduced inside the plant, the plant is closed and placed under a vacuum, the substrate is processed and then the reel of processed and rewound substrate is extracted from the plant so as to be replaced with a new reel of web-like substrate to be processed.

A description of the characteristics of the problems of these plants may be found in "A New Generation of Film Metallizing" by G. Tonini, F. Grazzini, N. Merlini, in Paper, Film & Foil Converter, February 1980.

The vaporization sources may have various configurations. Known configurations include vaporization sources consisting of electrically conductive material and heated by means of the direct passage of current. The source in this case takes the form of a bar made of conductive material, for example ceramic material, or sintered metal powders. The bar has an elongated extension in a main longitudinal direction. The source has a configuration such as to allow the formation of a pool of molten metal on its surface directed toward the substrate to be metallized. This configuration generally consists of a cavity which may be defined by a hollowed or lowered portion of the surface of the conductive bar. Alternatively, and in a manner known per se, the pool may be formed along light and practically undetectable surface incisions formed in the bar. In both cases a kind of cavity is formed on the upper surface of the bar forming the source. In this zone, the droplets of molten metal obtained from heating of the metal wire, usually aluminum, are deposited so as to form a pool from which the metal evaporates.

The metal is vaporized in a continuous manner and continuously fed to the source in the form of wire which is unwound from a reel. A description of this type of source may be found in AA. W. "Veredeln von Kunstoff-Oberflächen", Carl Hanser Verlag, Munich, Vienna, 1974, page 120 et seq., and in US-A-5,321,792.

One of the most delicate aspects of these sources and of these plants consists in the need to deposit extremely uniform coatings of metal onto the substrate which passes above the sources. For this purpose, particular arrangements of the sources which tend to reduce as far as possible the lack of uniformity in the characteristics of the deposited layer have been studied.

A further critical aspect of the vacuum metallization plants consists in the production speed which can be reached. This depends in fact on the quantity of metal which can be vaporized per unit of time and therefore, ultimately, on the extension of the surface area to be vaporized. In direct-heating sources, which have a form elongated in the direction of feeding of the substrate and a cavity for the molten metal, it is in theory possible to increase the planwise dimension of the cavity in order to increase the surface area of evaporating metal. However, owing to the effect of the surface tension in the liquid, the molten metal is deposited inside the cavity without filling it completely, but forming a pool of circular or elliptical shape. Consequently, the vaporization surface area is smaller than the surface area of the cavity and cannot be increased. An increase in the number of vaporization sources, on the other hand, would be limited by the cost and dimensions of the sources.

An example of a particular solution in the arrangement of the sources is indicated in DE-A-4027034. Here the sources are arranged alongside each other in a direction perpendicular to the direction of feeding of the web-like substrate and are slightly staggered with respect to each other in the direction of feeding of the substrate.

### Objects and summary of the invention

The object of the present invention is to provide a vacuum metallization plant which allows an increase in the surface area of the evaporating liquid and hence the quantity of evaporated metal, while keeping unaltered the number of heating systems, i.e. sources, and an increase in the uniformity of the coating deposited on the substrate.

These and further objects and advantages, which will become clear to those skilled in the art from reading of the text below, are essentially obtained with a vacuum metallization plant of the type mentioned above, characterized in that each of the sources is suitable for forming thereon at least two pools of molten metal, which are preferably arranged so as to be approximately aligned in the main longitudinal direction of the source itself, in that each of said pools of molten metal is fed with a respective metal wire supplied by a respective supplying means and in that said sources are arranged with their main longitudinal direction inclined with respect to the direction of feeding of the substrate at an angle other than 0° and 90°.

The formation of two or more pools therefore allows an increase in the surface area of molten metal and thus the quantity of material which is vacuum-deposited on the substrate. The pools may be formed in cavities defined by hollowed or lowered zones in the surface of the bar forming the source.

Moreover, the inclined arrangement with respect to the direction of feeding of the substrate to be metallized allows an increase in the uniformity of the deposition.

By envisaging the formation of one or more pools on the same source, the surface area of the expanse of molten metal contained in the vaporization source is physically divided into two or more parts. Consequently, it is possible to obtain evaporating surfaces which are particularly extensive and therefore a deposition of large quantities of metal per unit of surface area of the substrate.

Although it is possible to envisage the use of a single cavity with a large longitudinal dimension, which is fed at its two ends by two metal wires, in this case the two melting wires would form two adjacent pools of metal inside the same cavity, which pools would make contact with each other in an entirely random manner for example following falling of the droplets of molten metal. The contact between the pools of molten metal inside the same cavity may give rise to disturbances and also splattering of liquid metal onto the substrate, with consequent damage of the substrate itself. These drawbacks are avoided by physically dividing the cavity into two, such that each pool of metal is isolated from the other one.

The division of the evaporating zone into two cavities also has a further advantage: When a droplet of metal falls onto the source in order to restore the evaporated material, it causes disturbances due to the propagation of the surface ripples which affect a surface area equivalent to half the overall vaporizing surface area, with a consequent greater uniformity in the deposition of the metal on the substrate.

Further advantageous features of the plant and the sources according to the invention are indicated in the accompanying claims.

### Brief description of the drawings

The invention will be better understood by referring to the description and the attached drawing, which shows a practical non-limiting example of the invention itself. In the drawing:
Fig. 1 shows a schematic side view of a metallization plant;
Fig. 2 shows a detailed side view of a source and the associated means for feeding the metal wire;
Figs. 3, 4 and 5 show plan views of possible configurations of the sources, with the formation of two or three pools of molten metal; and
Figs. 6 and 7 show schematic plan views of two possible arrangements of the sources inside the plant, in the first case with feeding of two metal wires and formation of two pools of metal and in the second case with feeding of three metal wires and formation of three pools.

### Detailed description of the preferred embodiment of the invention

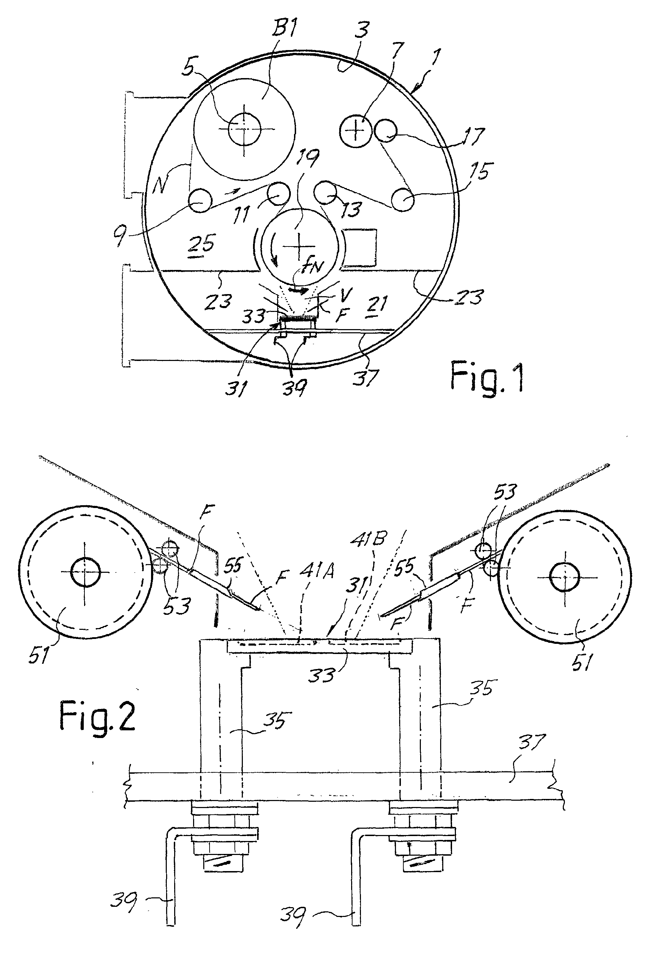

Fig. 1 shows in very schematic form a side view of the inside of a plant for metallization by means of vacuum vaporization.

Said plant comprises a container 3 housing two supports 5 and 7 for the reels of the web-like substrate to be metallized. The support 5 has, arranged on it, a reel B1 of substrate yet to be processed, which is fed along a feeding path defined by driving rollers 9, 11, 13, 15, 17. The support 7 supports a second reel being formed, on which the substrate is wound after metallization.

A processing roller 19 of larger diameter is arranged between the roller 11 and the roller 13, said roller 19 projecting partially inside a chamber 21 separated by means of a wall 23 from the overlying chamber 25 where the supports 5 and 7 for the reels of substrate are arranged. The chamber 21 is kept under a vacuum which is greater than that of the chamber 25. There are also plants in which the separating wall 23 and the subdivision into chambers 21 and 25 does not exist. In this case the unwinding reel, the rewinding reel, the travel path of the substrate N, the processing roller 19 and the vaporization sources are all located inside the same chamber.

The web-like substrate N unwound from the reel B1 and driven around the processing roller 19 is gradually rewound so as to form a reel of metallized substrate on the support 7. During unwinding, a metal which has been vaporized by a series of sources 31 which are located inside the chamber 21 underneath the processing roller 19 is deposited on the surface of the web-like substrate N not in contact with the processing roller 19, as it passes around the processing roller 19. V denotes schematically the vaporized material emitted by the sources 31 which are arranged alongside each other in an alignment perpendicular to the direction FN of feeding of the substrate N, i.e. perpendicularly with respect to the plane of the figure. Only one source is therefore visible in Fig. 1.

The structure of the metallization plant may vary and that which is shown in Fig. 1 is exclusively a schematic example of a possible plant in which the invention may be implemented.

Fig. 2 shows an enlarged side view of a source 31 of the plant according to Fig. 1. This source consists of a bar 33 made of electrically conductive material which is resistant to high temperatures, typically in the region of 1500 °C. It has an elongated extension in a main longitudinal direction indicated by DL.

The bar 33, which is also technically called a "boat", is supported by mechanical support means which also provide an electrical contact with a low-voltage power supply line. In the example shown, two columns 35 integral with a support plate 37 are envisaged. The columns 35 are electrically conductive and connected to two electrical conductors 39 by means of which a current flow is circulated inside the boat 33, which current flow dissipates heat as a result of the Joule effect, heating the bar or boat 33.

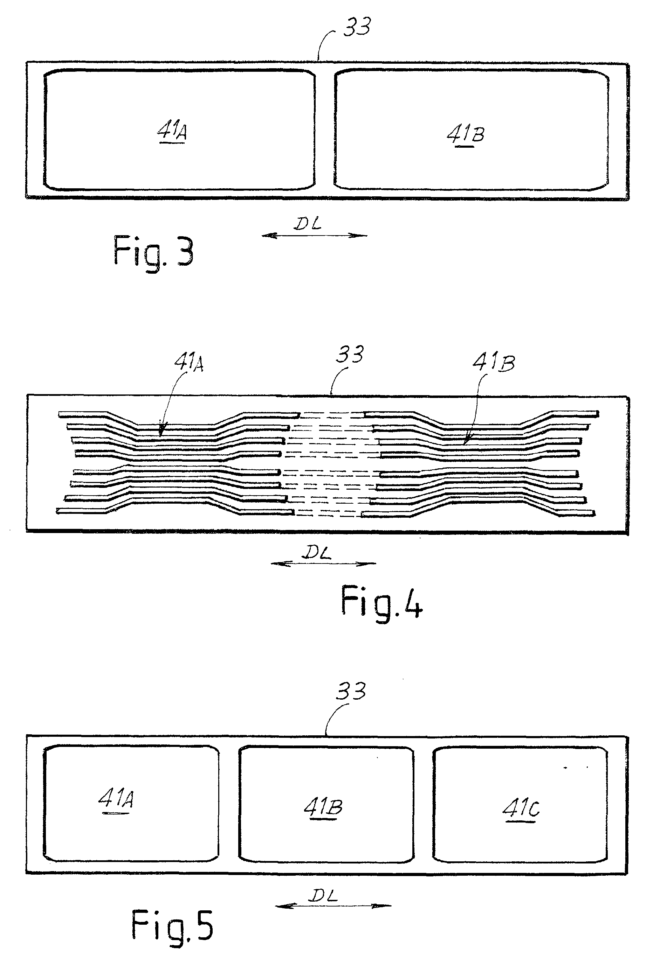

As shown in detail in the example according to Fig. 3, each bar or boat 33 of each source 31 has two cavities 41A, 41 B of limited depth, with a flat bottom and a substantially rectangular extension in plan view (see Fig. 3). Pools of liquefied metal are formed in these cavities 41A, 41B, which metal vaporizes, absorbing the heat generated as a result of the Joule effect by the current flow across the bar or boat 33.

In order to maintain inside the cavities 41A, 41B the desired level of liquid metal and therefore restore the metal which is supplied by the vaporization source, two separate means supplying a metal wire which is intended to be melted by means of irradiation heating by the bar 33 and to fall in the form of droplets inside the cavities 41A and 41B are envisaged.

The metal wire supplying means are schematically shown in Fig. 2 and may assume different forms. These supplying means are of the type known per se and are not described in particular detail here. Schematically in the example shown, they envisage a spool 51 of metal wire F, a pair of small cylinders 53, at least one of which is motorized, for drawing the metal wire F and unwinding it from the spool 51 and feeding through a guide tube 55. The metal wire F emerges from the tube 55 in a zone situated above the respective cavity 41A or 41B.

The free end of the wire F emerging from the tube 55 gradually melts owing to the effect of the heat generated by the current which flows inside the boat bar 33. The drops of molten metal fall into the respective cavity and vaporize. Suitable systems not shown and known per se ensure the necessary length of wire F projecting from the tube 55 is maintained and cause gradual unwinding of the wire F by means of the cylinders 53 from the spool 51.

The presence of two separate cavities on each bar or boat 33 and the supplying of each of them by means of a separate metal wire ensures that the disturbances caused by falling of the droplets of molten metal into the pools formed inside the cavities 41A, 41B are limited, thereby contributing to the uniformity of coating of the substrate M.

In the example shown in Fig. 4, the bar or boat 33 again has means for forming two pools of molten metal, located at a distance from each other, i.e. physically separated, and aligned in the main longitudinal direction DL of the bar 33. In this case, the zones in which the pools of molten metal are formed each consist of a series of superficial incisions in the bar, having a linear progression and arranged closer together in the central zone. These two arrangements of incisions are again indicated by 41A and 41B and are fed with two metal wires in a similar way to that described above. in reality the incision may not involve the removal of a substantial amount of material such that each incision does not consist of a groove in the material, but for example solely an alteration in the surface characteristics of the material itself, such as for example an alteration of its roughness, with the aim of modifying the surface tension during contact between bar and molten metal, and therefore the wettability of the surface of the source, with a consequent limitation of the zone concerned to the pool of molten metal. The incisions may also be continuous, as shown in broken lines in the figure. This type of incision machining is known per se to persons skilled in the art, but has not been used for the production of this type of sources. The incision lines are typically formed by means of laser machining.

Fig. 5 shows a bar similar to that in Fig. 3, but with three cavities 41A, 41B, 41C which are aligned with each other in the main longitudinal direction DL so as to form three distinct and separate pools of molten metal. In this case also the cavities may be replaced in an equivalent manner by incisions as described with reference to Fig. 4.

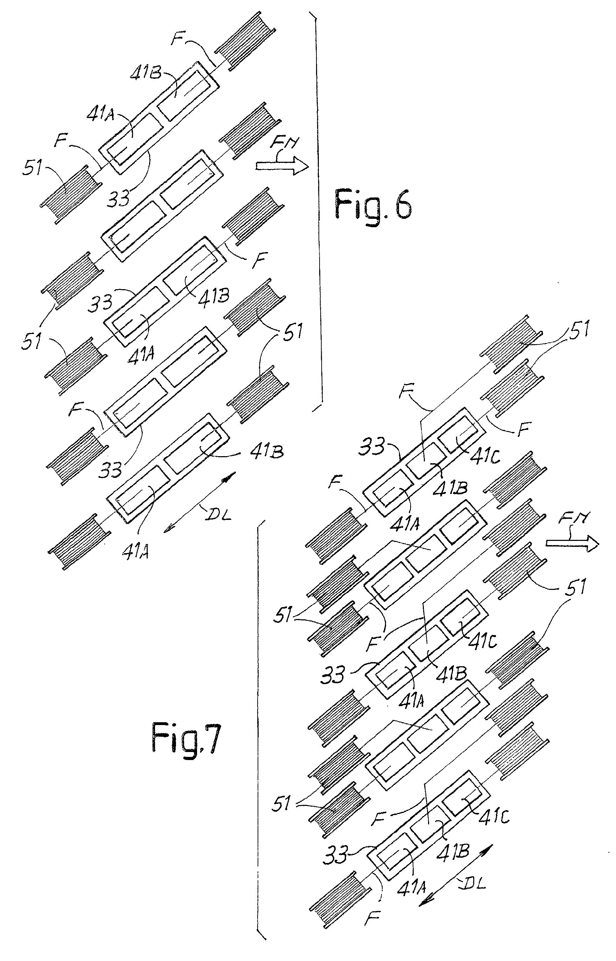

As shown in the plan view according to Fig. 6, in which a series of sources of the type illustrated in Fig. 3 can be seen in plan view, the sources 31 are arranged next to each other in an alignment A which is transverse to the direction of feeding of the substrate and in particular perpendicular to the direction of feeding FN of the substrate to be metallized. The various sources 31 are arranged parallel to each other, i.e. with the respective main longitudinal direction DL oriented in the same common direction. Each of the sources 31 is arranged, with respect to the direction FN of feeding of the substrate with an orientation such that they assume a "fish-bone" configuration. Basically the main longitudinal direction DL of each source 31 forms an angle of between for example 15° and 60° with respect to the direction FN and preferably between 20° and 50°. In the example shown, the sources have an inclination of 30° with respect to the direction FN. In this way there is overlapping between the various pools of molten metal in the direction FN of feeding of the substrate to be metallized and this allows a greater uniformity of deposition to be obtained compared to the conventional arrangement of the sources parallel to the direction FN.

Each source is fed with two metal wires supplied on opposite sides of the series of sources aligned with each other in the alignment A. The alignment A is preferably oriented at 90° with respect to the direction FN, but it may be understood that reasonably limited variations of this arrangement are possible.

Fig. 7 shows a plan view similar to the view shown in Fig. 6, with the use of sources comprising three pools of the type illustrated in Fig. 5. Each source is fed by three metal wires supplied by spools arranged alternately on the two sides of the series of sources 31.

It is understood that the drawing shows only one example of embodiment of the invention, the forms and arrangements of which may vary without thereby departing from the idea underlying the invention. For example, the spools of metal wires may be arranged in a different manner from that shown. Moreover, it is possible to envisage also multiple arrangements of that shown, for example with two adjacent series of sources 31, the sources of one series forming with the direction of feeding FN of the web-like substrate an angle different from that of the sources of the other series.

## Claims

1. A vacuum vaporization plant for the metallization of a web-like substrate, comprising:
- a plurality of vaporization sources supplied with a metal which is liquefied and vaporized by said sources, each source having a body elongated in a respective main longitudinal direction;
- means for feeding said substrate above said sources, in a feeding direction, said sources being arranged alongside each other in an alignment substantially perpendicular to said feeding direction;
- means for supplying said metal wire to said sources;
- means for supporting and heating said sources;
**characterized in that** each of said sources is suitable for forming thereon at least two pools of molten metal, **in that** each of said pools of molten metal is fed with a respective metal wire supplied by a respective supplying means and **in that** said sources are arranged with their main longitudinal direction inclined with respect to the direction of feeding of the substrate at an angle other than 0° and 90°.

2. Plant according to Claim 1, **characterized in that** said at least two pools of each source are aligned with each other approximately in the main longitudinal direction of the source itself.

3. Plant according to Claim 1 or 2, **characterized in that** the angle between the main longitudinal direction of each source and the direction of feeding of the substrate is such as to position mutually the pools of liquid metal of adjacent sources so that they are at least partially staggered in the direction of said alignment, substantially perpendicular to the direction of feeding of the substrate.

4. Plant according to Claim 1 or 2 or 3, **characterized in that** each of said sources has at least two zones with a respective surface depression so as to form a respective pool of molten metal.

5. Plant according to Claim 4, **characterized in that** each of said surface depressions is formed by a plurality of superficial incision lines.

6. Plant according to Claim 1, 2 or 3, **characterized in that** each of said sources has at least two zones for the formation of pools of liquid metal, each zone being defined in the region of a plurality of superficially processed lines.

7. Plant according to Claim 6, **characterized in that** said superficially processed lines are superficial incision lines.

8. Plant according to Claim 4, **characterized in that** each of said superficial depressions is formed by a single lowered surface portion of said source.

9. Plant according to one or more of the preceding claims, **characterized in that** the angle between the main longitudinal direction of the sources and the direction of feeding of the substrate is between 15° and 60° and preferably between 20° and 55° and even more preferably between 25° and 45°.

10. A source for the vacuum vaporization of a metal or the like, comprising a body made of electrically conductive material elongated in a main longitudinal direction, **characterized in that** it has a surface suitable for forming at least two pools of molten material on said surface, incisions being formed on said surface so as to define at least two zones where said pools of molten metal are formed.

11. Source according to Claim 10, **characterized in that** said incisions have a linear progression and are arranged closer to each other in the zones intended to form the pool of molten metal.

12. Source according to Claim 10 or 11, **characterized in that** it comprises a series of incisions which extend along said elongated body and which have at least two zones in which said incision lines are located close to each other.

13. Source according to one or more of Claims 10 to 12, **characterized in that** said two pools are aligned approximately in the main longitudinal direction of extension of said elongated body.

14. Source according to one or more of Claims 10 to 13, **characterized in that** said incisions alter the superficial wettability of the surface of the source in the zones where said at least two pools must be formed.

15. Source according to one or more of Claims 10 to 14, **characterized in that** said incision lines are laser incision lines.
